# EUROPÄISCHE PATENTANMELDUNG

(11) **EP 1 418 659 A1**
(43) Veröffentlichungstag der Anmeldung: **12.05.2004**
(21) Anmeldenummer: 02024844.9
(22) Anmeldetag: 07.11.2002
(51) Int. Cl.: H02K 11/00

(54) **Überwachung parallel geschalteter Ständerwicklungen**

(71) Anmelder: SIEMENS AKTIENGESELLSCHAFT, 80333 München (DE)
(72) Erfinder: Klaar, Juergen, 47506 Neukirchen-Fluyn (DE)

(57) **Zusammenfassung**

Die Erfindung betrifft eine Überwachungs- und Meldevorrichtung in einem Turbogenerator, der eine Ständerwicklung mit einen ersten und einen zweiten Wicklungszweig aufweist, zur frühzeitigen Erkennung von Störungen. Dabei ist je eine Messeinrichtung pro Wicklungszweig vorgesehen zur Messung einer physikalischen Größe, wobei durch Vergleich einer Messung im ersten Wicklungszweig und einer Messung im zweiten Wicklungszweig ein Differenzwert ermittelt wird und bei Überschreitung eines vorbestimmten Grenzwert eine Störung erkannt wird.

## Beschreibung

Die Erfindung betrifft eine Überwachungs- und Meldevorrichtung in einem Turbogenerator, der eine Ständerwicklung mit einem ersten und einem zweiten Wicklungszweig aufweist, zur frühzeitigen Erkennung von Störungen.

In Turbogeneratoren ist die Ständerwicklung meistens in mehrere Wicklungszweige aufgeteilt, um dadurch die Ströme, die durch die einzelnen Wicklungszweige fließen, aufzuteilen. Die Konstruktion der einzelnen Wicklungszweige ist derart, dass im störungsfreien Betrieb die Stromaufteilung in den einzelnen Wicklungszweigen symmetrisch erfolgt. Tritt ein Schaden oder eine Störung im Wicklungskreis auf, so kann eine durch die Störung oder den Schaden verursachte Widerstandsänderung die Stromaufteilung zwischen den einzelnen Wicklungszweigen ändern. Die Stromaufteilung kann danach unsymmetrisch erfolgen. Die Schäden bzw. die Störungen im Wicklungszweig können durch gebrochene Teilleiter, gebrochene oder aufgegangene Verbindungen in Einzelteilleitern oder Teilleiterbündeln zwischen Ober- und Unterlagestab, reduziert Kühlmengen oder mehrere Teilleiterschlüsse in einem Wicklungszweig, die zu partiellen Überhitzungen von Wicklungsteilen führen können, hervorgerufen werden. Derzeit werden Turbogeneratoren ohne eine geeignete Überwachungseinrichtung installiert. Dies kann dazu führen, dass die vorgenannten Schäden nicht rechtzeitig erkannt werden und ein Totalschaden des Turbogenerators mit langen Ausfallzeiten zur Folge hat.

Aufgrund der Liberalisierung des Marktes in der Elektrizitätswirtschaft werden die Turbogeneratoren künftig häufiger mit ihrem Bemessungsstrom über längere Zeit hinweg belastet. Im Vergleich zur bisherigen Praxis werden die Turbogeneratoren dadurch thermisch und mechanisch stärker beansprucht. Störungen bzw. Schädigungen in Turbogeneratoren sind häufig erst bei Inspektionen oder bei Stillstandsuntersuchungen festgestellt worden. Unter Umständen sind die Schädigungen infolge von Schäden bzw. Störungen in Wicklungskreisen soweit fortgeschritten, dass die Turbogeneratoren über andere Schutzmechanismen unerwartet vom Einspeisungsnetz gehen.

Aus der DE 196 29 483 A1 ist ein Verfahren zur Überwachung von in Sternschaltung betriebenen Wicklungen des Stators einer elektrischen Maschine beschrieben. Dabei wird die Nullspannung an den Klemmen der Wicklungen gemessen und ihr betriebsfrequenter Anteil als Hilfsmessgröße zur Gewinnung eines Auslösesignals herangezogen und aus der Nullspannung Oberwellen unter Gewinnung einer Zwischenmessgröße ausgefiltert und die Zwischenmessgröße zur Bildung eines weiteren Auslösesignals herangezogen.

In der DE 36 00 421 A1 wird eine Vorrichtung und ein Verfahren vorgestellt zur Feststellung und Ortung von lokalen Überwärmungen in flüssigkeitsgekühlten Wicklungen elektrischer Maschinen. Dabei werden die in dem Kühlmittel einer elektrischen Maschine bei lokaler Überwärmung auftretenden Blasengeräusche registriert, was beispielsweise durch Schallaufnehmer erfolgen kann. Durch geeignete frequenzselektive Filter können Störgeräusche ausgefiltert werden. Durch Messungen der Laufzeitdifferenzen, mit denen die Blasengeräusche bei den verschiedenen Schallaufnehmern eintreffen, kann der schadhafte Wicklungsstab unmittelbar bestimmt werden.

Aufgabe der Erfindung ist es, eine Einrichtung und ein Verfahren vorzustellen, die Störungen oder Schäden in einer Ständerwicklung mit mehreren Wicklungszweigen frühzeitig erkennt und meldet.

Die Aufgabe wird gelöst durch einen Turbogenerator, der eine Ständerwicklung mit einem ersten und einem zweiten Wicklungszweig aufweist, wobei eine Überwachungs- und Meldevorrichtung vorgesehen ist, die Messeinrichtungen für die Messung einer physikalischen Größe im ersten Wicklungszweig und eine zweite Messeinrichtung im zweiten Wicklungszweig aufweist und durch Vergleich einer Messung im ersten Wicklungszweig und einer Messung im zweiten Wicklungszweig ein Differenzwert ermittelt wird und bei Überschreitung eines vorbestimmten Grenzwertes eine Störung erkannt und gemeldet wird.

Mit dieser Einrichtung ist es möglich, Störungen bzw. Schäden in den Wicklungszweigen frühzeitig zu erkennen und zu melden. Damit können entsprechende Maßnahmen, wie z.B. Leistungsreduzierung, Blindleistungsbeschränkung eingeleitet werden, die die Maschine vor größeren Folgeschäden bewahrt.

In einer vorteilhaften Ausgestaltung weist die Messeinrichtung einen Stromwandler auf, zur Messung eines elektrischen Stromes. Durch die Messung des elektrischen Stromes in den einzelnen Wicklungszweigen wird eine Größe gemessen, die unmittelbar durch Störungen oder Schäden im Wicklungszweig beeinflusst ist. Man gewinnt dadurch den Vorteil die Störung bzw. die Schäden sofort zu erkennen, um entsprechende Maßnahmen einzuleiten.

Eine weitere sensitive Größe, die unmittelbar durch Schäden bzw. Störungen um Wicklungskreis beeinflusst werden, ist die Temperatur, die im Wicklungskreis auftritt. Daher weist die Messeinrichtung in einer vorteilhaften Ausgestaltung einen Temperatursensor auf. Durch Messung der Temperatur in den einzelnen Wicklungszweigen wird eine Störung bzw. ein Schaden im Wicklungsstab detektiert. Entsprechende Maßnahmen können auch hier schnell eingeleitet werden.

In einer vorteilhaften Ausgestaltung besteht der Stromwandler aus einem faseroptischen Stromwandler. Durch die Anordnung eines faseroptischen Stromwandlers gewinnt man den Vorteil, dass nicht der gesamte elektrische Strom durch den Stromwandler fließen muss, der in Turbogeneratoren einige Ampere betragen kann, sondern es wird eine indirekte Messmethode eingesetzt, die aus faseroptischen Stromwandlern bestehen.

In einer weiteren Ausgestaltung besteht der Temperatursensor aus einem faseroptischen Temperatursensor. Auch hier gewinnt man den Vorteil, dass die Temperatur indirekt gemessen wird. Die Dissipation von Energie wird hierdurch auf ein Minimum reduziert.

In einer weiteren Ausgestaltung werden die faseroptischen Stromwandler in den einzelnen Wicklungszweigen in Reihe geschaltet und zur jeweiligen Stromrichtung gegenläufig ausgeführt. Bei einer symmetrischen Stromaufteilung ist das resultierende Signal aus dieser Einrichtung Null. Tritt ein Schaden bzw. eine Störung auf, hat dies eine unsymmetrische Stromverteilung zur Folge und somit wird in den einzelnen faseroptischen Stromwandlern ein unterschiedlicher Wert gemessen, der schließlich zu einem resultierenden Wert führt, das ausgewertet wird und bei einer zu großen Abweichung als Störung gemeldet wird.

In einer weiteren vorteilhaften Ausgestaltung wird ein Speichermedium eingesetzt, in das Daten gespeichert werden, die während eines störungsfreien Betriebes des Turbogenerators aufgenommen werden. Man gewinnt hier den Vorteil, dass aktuelle im Betrieb gemessene Werte der physikalischen Größen direkt mit den gespeicherten Werten aus dem störungsfreien Betrieb verglichen werden können. Signifikante Änderungen zwischen den beiden Werten wird als Störung bzw. als Schaden im Wicklungszweig interpretiert und weiter verarbeitet.

Die auf das Verfahren hin gerichtete Aufgabe wird durch während des Betriebes durchgeführte sporadische oder zyklische Differenzmessung gelöst, deren Messwerte mit den gespeicherten Messwerten, die während eines störungsfreien Betriebes aufgenommen wurden, verglichen werden. Bei signifikanten Unterschieden zwischen den sporadischen oder zyklisch aufgenommenen Differenzmessungen und der während des störungsfreien Betriebes aufgenommenen und gespeicherten Differenzmessungen wird dies als Störung oder als Schaden im Wicklungszweig interpretiert. Entsprechende Maßnahmen können anschließend schnell erfolgen.

Die Erfindung wird anhand der folgenden Figuren näher erläutert. Einander entsprechende Teile erhalten die gleichen Bezugszeichen.

Dabei zeigen:
- Figur 1: einen Schnitt durch ein Turbogenerator;
- Figur 2: ein Wicklungsbild der Ständerwicklung eines Turbogenerators;
- Figur 3: Anordnung eines Ringleitungssystems mit faseroptischen Temperatursensoren;
- Figur 4: Messanordnung zur Messung des elektrischen Stromes in den einzelnen Wicklungszweigen mit faseroptischen Stromwandlern.

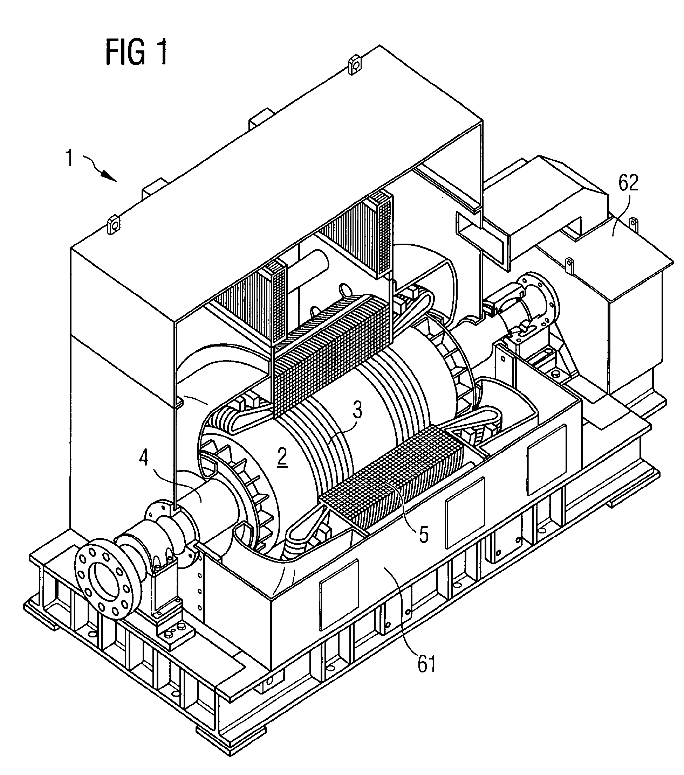

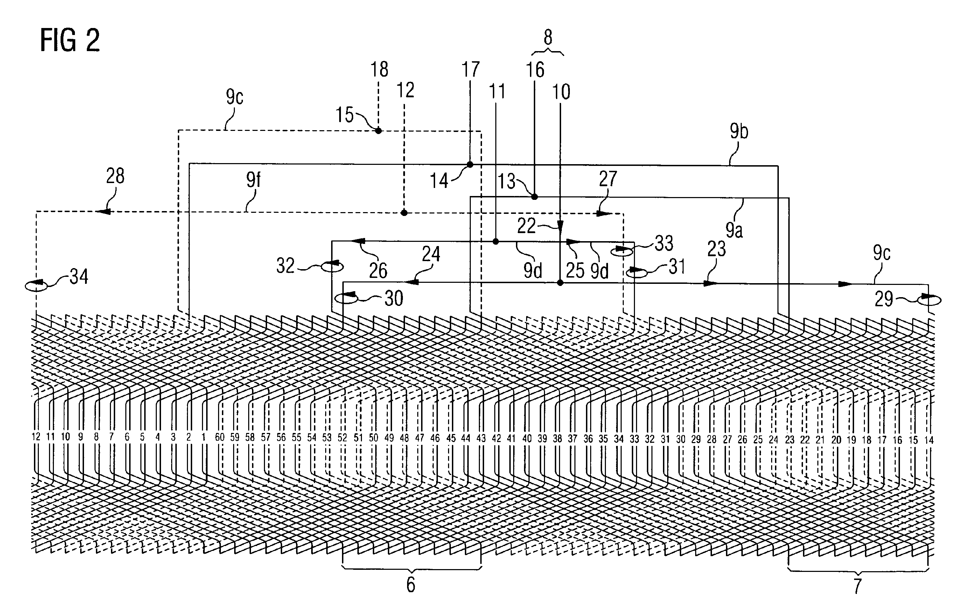

In Figur 1 ist ein Schnitt durch einen elektrischen Turbogenerator 1 dargestellt. Der Turbogenerator weist einen Rotor 2 auf. Um den Rotor 2 befindet sich die Läuferwicklung 3 durch die ein Erregerstrom über eine Erregerstromzuführung 62 während des Betriebs fließt. Um den um die Rotationsachse 4 drehbar gelagerten Rotor 2 befindet sich eine Ständerwicklung 5. Die Ständerwicklung 5 ist in mehrere Wicklungszweige, die in der Figur 2 näher dargestellt sind, aufgeteilt.

In Figur 2 ist ein Wicklungsbild der Ständerwicklung 5 eines Turbogenerators 1 dargestellt. Die Ständerwicklung 5 weist zwei parallele Wicklungszweige pro Phase 8 auf. Der Übersichtlichkeit wegen ist ein Paar der Wicklungszweige und die dazugehörige Phase mit einem Bezugszeichen versehen. Durch den elektrischen Strom, der durch die Läuferwicklung 3 fließt, entsteht ein Magnetfeld. Mit der Drehung des Rotors 2 um die Rotationsachse 4 rotiert das Magnetfeld um die Rotationsachse 4. Das zeitlich sich ändernde Magnetfeld induziert in einem Wicklungszweig 6, 7 eine Spannung. Die Wicklungszweige 6, 7 sind in der Ständerwicklung 5 derart angebracht, dass die induzierten Spannungen zu einer Phase 8 zusammengefasst werden.

Die Ständerrichtung 5 weist vier weitere Wicklungszweige auf, wovon jeweils zwei wiederum zu einer Phase zusammengefasst werden. Der Übersichtlichkeit wegen, wird die Erfindung anhand der Phase 8 und der Wicklungszweige 6, 7 näher erläutert. Die Ausführungen können auf weitere Phasen und Wicklungszweige angewandt werden.

Die Enden der Wicklungszweige 6, 7 werden zu sogenannten Ringleitungen 9a, 9b, 9c geführt. Die Ringleitungen 9a, 9b, 9c werden über Wicklungsabschlüsse 13, 14, 15 zu den Phasenseiten U1 (10), V1 (11) und W1 (12) zusammengefasst. Das andere Ende der Wicklungszweige 6, 7 wird ebenfalls zu Ringleitungen 9d, 9e, 9f geführt. Über weitere Wicklungsabschlüsse 19, 20, 21 werden die Ringleitungen 9d, 9e, 9f zu sogenannten Sternpunktseiten U2 (16), V2 (17), W2 (18) zusammengefasst. Zwischen der Phasenseite 10, 11, 12 und der Sternpunktseite 16, 17, 18 kann die induzierte Spannung abgegriffen werden. Wegen der induzierten Spannungen zwischen den Phasenseiten 10, 11, 12 und den Sternpunktseiten 16, 17, 18 fließt ein elektrischer Strom, der in Teilströme 23, 24; 25, 26; 27, 28 in den jeweiligen Wicklungszweigen aufgeteilt wird. Im störungsfreien Betrieb sind die Teilströme 23 - 28 gleich, es sei denn, durch unterschiedliche Längen der Ringleitungsabschnitte ist grundsätzlich eine geringe Differenz zwischen den Teilströmen vorhanden. Ein Vergleich der Teilströme 23, 24, 25, 26, 27, 28 zueinander ist nicht erforderlich, sie dürfen und können bei unsymmetrischer Belastung in gewissen Grenzen ungleich sein.

Zur Überwachung der Ströme sind faseroptische Stromwandler angebracht. Die faseroptischen Stromwandler 29 - 34 sind durch Kreise und Pfeile, die die Wicklungen der faseroptischen Stromwandler angeben, dargestellt.

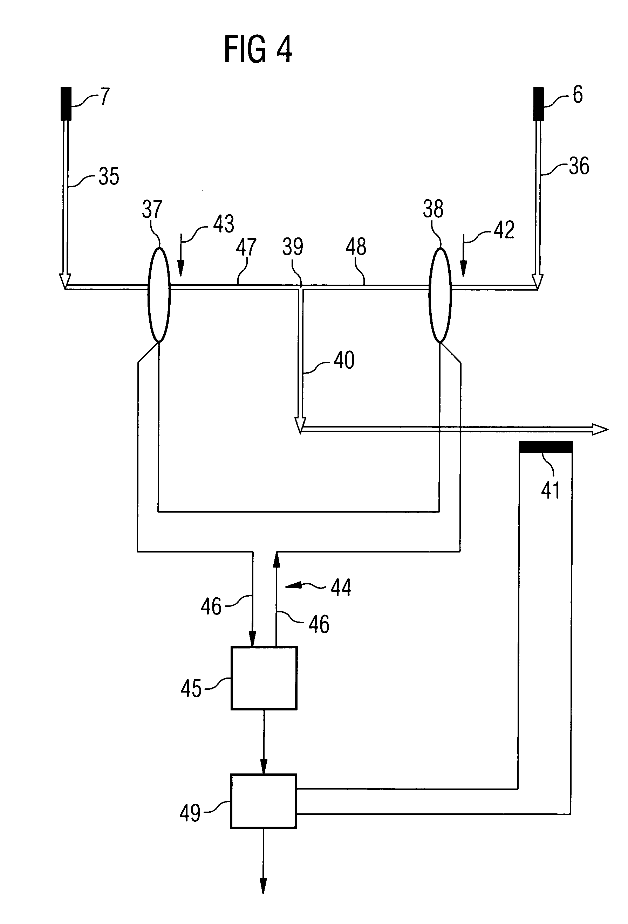

In der Figur 4 ist ein Blockschaltbild einer Schaltung zur Strommessung und der Weiterverarbeitung von Signalen der Wicklungen (6, 7) dargestellt. Der Übersichtlichkeit wegen wird der Aufbau lediglich für eine Phase 8 dargestellt, der Aufbau für die anderen Phasen ist analog. Die Wicklungszweige 6 und 7 liefern jeweils einem elektrischen Strom 35 und 36. Die elektrischen Ströme 35 und 36 werden mit faseroptischen Stromwandlern 37 und 38 vor der Zusammenschaltung in einem Knotenpunkt 39 erfasst. Nach dem Knotenpunkt 39 fließt der Gesamtstrom 40, der von einem üblichen Stromwandler 41 erfasst werden kann. Die Wicklungsrichtungen der faseroptischen Stromwandler sind gegenläufig, die durch Pfeile 42 und 43 angedeutet werden. Die faseroptischen Stromwandler 37 und 38 werden in Reihe geschaltet. Die Anzahl der faseroptischen Messdurchführungen wird dadurch halbiert.

Außerhalb des Turbogenerators 1 erfolgt über zwei Lichtwellenleiter 46 eine Verbindung der faseroptischen Stromwandler 37 und 38 zu einer Messeinrichtung 45. In der Messeinrichtung 45 wird Licht über die Lichtwellenleiter 46 zu den faseroptischen Stromwandlern 37 und 38 geführt. Durch die magnetischen Felder der stromdurchflossenen Leiter 47 und 48 erfolgt eine Phasendrehung des Lichtes, die von der Stromstärke in den stromdurchflossenen Leitern 47 und 48 abhängt. Für gleichgroße Stromstärken in den Leitern 47 und 48 wird die Phasendrehung, die in den einzelnen faseroptischen Stromwandlern 37 und 38 gegensinnig erfolgt, wieder aufgehoben. Für eine symmetrische Stromaufteilung in den Leitern 47 und 48 dürfte keine Phasendrehung des Lichtes erfolgen. Wird dennoch eine geringe Phasendrehung festgestellt, dann kann dies durch unsymmetrische Ströme oder durch ungleiche Stromwandler verursacht werden. Da eine aktuelle Messung im Vergleich zu einer aufgenommenen Nullkennlinie, die z.B. während der Inbetriebnahme aufgenommen wird, bewertet wird, muss keine Korrektur durchgeführt werden. Die Nullkennlinie wird in Abhängigkeit vom Gesamtstrom 40 aufgenommen und in einem Personal Computer PC 49 gespeichert. Während der Aufnahme der Nullkennlinie sollte ein thermisches Gleichgewicht erreicht sein.

Während des Betriebes des Turbogenerators 1 werden aktuelle Stromwerte 35, 36 und 40 erfasst und eine eventuelle Differenz zwischen den Ergebnissen aus der Messung der Ströme 35 und 36 dem Personal Computer 49 weitergeleitet und dort weiterverarbeitet. Im Personal Computer 49 wird die ermittelte Differenz mit dem zugehörigen Wert aus der Nullkennlinie verglichen. Der Nullkennlinie werden eine obere und eine untere Grenzlinie zugeordnet. Eine Störmeldung wird dann abgesetzt, wenn z.B. nach einer Mittelwertbildung von mindestens vier Messwerten, die Grenzlinien überschritten werden. Mit der Richtung der Abweichung kann darüber hinaus der störbehaftete Wicklungszweig erkannt werden. Entsprechende Maßnahmen zur Begrenzung eines möglichen Schadens können eingeleitet werden.

Sollten absolute Stromwerte erfasst und für die Bewertung herangezogen werden, dann muss auf die Reihenschaltung der Stromwandler verzichtet werden und jeder Stromwandler mit einer eigenen optoelektronischen Messeinrichtung ausgerüstet werden.

Durch die Messung und Bewertung von elektrischen Ströme oder der Temperaturen, die bevorzugt an den Ausgängen der parallelen Wicklungszweigen von allen drei Phasen gemessen werden, wird eine unsymmetrische und sich verändernde Stromverteilung in den einzelnen Wicklungszweigen erkannt. Störungen bzw. Schäden in den einzelnen Wicklungszweigen werden über die gemessenen Ströme direkt oder über die gemessene Temperatur indirekt in den Kupferleitungen vor den sogenannten Ring- oder Schaltleitungen erfasst. Eine Messung der Ströme oder der Temperaturen ist infolge der anliegenden Hochspannung und der großen elektrischen und magnetischen Feldern mit herkömmlichen Geräten nicht ohne weiteres möglich. Zur Strommessung werden deshalb faseroptische Stromwandler eingesetzt, die in jedem parallelen Zweig in jeder Phase installiert werden. Die beiden Messsignale bei einer einfachen Parallelschaltung werden gegeneinander geschaltet. Sind bereits im Neuzustand, d.h. man kann dann von einem störungsfreien Zustand ausgehen, kleine Unsymmetrien der Ströme in den parallelen Wicklungszweigen vorhanden und sind die Kennlinien der Strommesser unterschiedlich, dann werden zur Erstellung einer Nullkennlinie bei der Inbetriebnahme mehrere unterschiedliche Ständerströme jeweils bis zur Erreichung einer thermischen Gleichgewichtes angefahren und die Differenz der Ausgangssignale in Abhängigkeit von dem Ständerstrom zum Erstellen von Vergleichskennlinien registriert und in einem Softwareprogramm abgespeichert. Für eine dreiphasige elektrische Maschine entstehen so drei Vergleichskennlinien. Während des Betriebes werden nun in sporadischen oder festen Messzyklen die aktuellen Differenzen der Stromausgangssignale gemessen und mit der jeweiligen Vergleichskennlinie verglichen. Eine zulässige Toleranzbreite der Abweichung wird festgelegt, wobei eine Meldung über eine ungleiche Stromaufteilung mit Angabe der Phase ausgegeben wird, wenn die Grenzen überschritten werden. Es können daraufhin Sofortmaßnahmen ergriffen werden. Es kann z.B. eine Einschränkung des zulässigen Ständerstromes zur Vermeidung einer thermischen Überlastung der Wicklung festgelegt werden, um eine Weiterentwicklung der Störung zu begrenzen bzw. zu verhindern. Sind mehr als zwei Zweige pro Phase vorhanden, dann ist ein Vergleich der Teilströme jedes Zweiges mit dem anderen innerhalb einer Phase erforderlich. Die Auswertung erfolgt analog zu den vorgenannten Schritten.

Die indirekte Vergleichsmethode der Stromaufteilung über die Messung der Kupfertemperaturen am Ausgang der Wicklung vor dem Anschluss an die Ringleitung erfordert einen Temperaturmesssystem, das von den oben genannten physikalischen Größen unabhängig ist. Dafür können einzelne faseroptische Temperatursensoren eingesetzt werden. Die Kosten für solch ein Messsystem sind vergleichsweise hoch, daher wird die Temperaturmessung mit faseroptischen Sensoren mit einer Braggfaser vorgeschlagen, mit der es möglich ist, mit nur einer Glasfaser, die zu den einzelnen Messpunkten verlegt sein muss, an verschiedenen Orten die Temperaturen zu messen. Bei der Auswahl der Messstellen ist auf die Richtung des Kühlgases zu achten, weil die Kühlung durch das Kühlgas die Temperatur längst des Wicklungszweiges stark beeinflusst. Als Messstelle für jeden Wicklungszweig wird eine Stelle ausgesucht, an der die höchste Erwärmung in der Kupferanschlussleitung vor der elektrischen Verbindung zur Ringleitung erwartet wird. Thermische Einflüsse von der Ringleitung sollten durch einen genügenden Abstand der Messstelle vermieden werden. Die Braggfaser wird direkt auf die Kupferleitungen unter die Isolierung angebracht.

Die Messung und Bewertung mit den Temperatursensoren erfolgt analog zu den vorher beschriebenen Messungen und Auswertungen mit den faseroptischen Stromwandler.

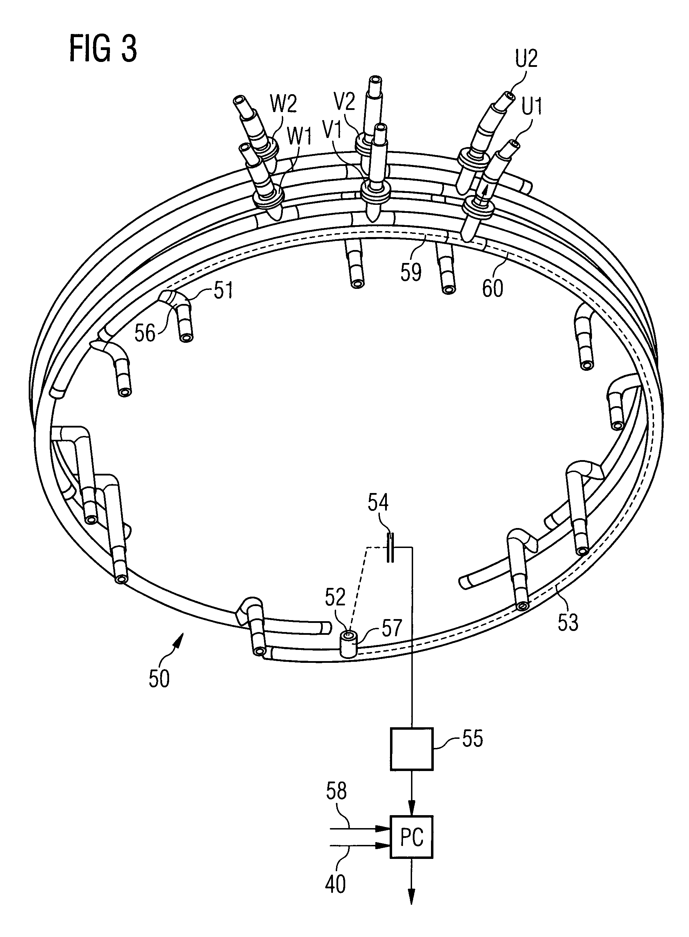

In der Figur 3 ist die Anordnung eines Ringleitungssystems 50 mit faseroptischen Temperaturensensoren 51 und 52 für eine Phase dargestellt. Die Leitungsverlegung mit einer Braggfaser ist durch die gestrichelte Linie 53 angedeutet. Die Braggfaser 53 wird durch eine Messdurchführung 54 aus dem Turbogenerator 1 zu einer optoelektronischen Messeinrichtung 55 weitergeleitet. In der optoelektronischen Messeinrichtung 55 wird die absolute lokale Temperatur an den Messstellen 56 und 57 ermittelt. Für die Aufnahme der Nullkennlinie werden der Gesamtstrom 40 und die Kühlmitteltemperatur 58 ebenfalls gemessen. Bei einer wasserstoffgekühlten Maschine sollte der Nenndruck eingestellt sein. Aus den Temperaturen werden die Erwärmungen in Abhängigkeit vom Quadrat des Stromes ermittelt und als Nullkennlinie abgespeichert. Während des Betriebes wird wie weiter oben dargestellt eine Vergleichsmessung durchgeführt und bewertet. Im Falle eines detektierten Schadens oder einer Störung erfolgt eine Zuordnung des fehlerhaften Zweiges bei entsprechender Abweichung der Erwärmung. Eine Einleitung von Gegenmaßnahmen zur Beseitigung oder zumindest zur Verminderung der Schäden ist möglich.

Sind mehr als zwei parallele Zweige vorhanden, müssen mehrere Messkreise aufgebaut werden.

Werden die Ringleitungen mit Gas oder Wasser gekühlt, können durch auftretende Fehler deren Volumenströme reduziert werden, was zu einer thermischen Überlastungen führen könnte. Während der Installation der Braggfaser ist es daher sinnvoll, auch die Ringleitung im Bereich des Gasaustritts mit Temperatursensoren 59 und 60 zu überwachen. Aus der Differenz der Temperaturen 51 und 59 bzw. 52 und 60 kann unter Berücksichtigung der Stromaufteilung auf eine Änderung der Volumenströme zurückgeschlossen werden. Zur Vervollständigung müssen dann auch die sternpunktseitigen Ringleitungen messtechnisch erfasst werden.

### Bezugszeichenliste

- 1: Turbogenerator
- 2: Rotor
- 3: Läuferwicklung
- 4: Rotationsachse
- 5: Ständerwicklung
- 6: Wicklungszweig
- 7: Wicklungszweig
- 8: Phase
- 9a - f: Ringleitungen
- 10: Phasenseite U1
- 11: Phasenseite V1
- 12: Phasenseite W1
- 13: Wicklungsabschluss
- 14: Wicklungsabschluss
- 15: Wicklungsabschluss
- 16: Sternpunktseite U2
- 17: Sternpunktseite V2
- 18: Sternpunktseite W2
- 19: Wicklungsabschluss
- 20: Wicklungsabschluss
- 21: Wicklungsabschluss
- 22: Phasenstrom
- 23: Teilstrom U1a
- 24: Teilstrom U1b
- 25: Teilstrom V1a
- 26: Teilstrom V1b
- 27: Teilstrom W1a
- 28: Teilstrom W1b
- 29: faseroptische Stromwandler
- 30: faseroptische Stromwandler
- 31: faseroptische Stromwandler
- 32: faseroptische Stromwandler
- 33: faseroptische Stromwandler
- 34: faseroptische Stromwandler
- 35: Strom
- 36: Strom
- 37: faseroptische Stromwandler
- 38: faseroptische Stromwandler
- 39: Knotenpunkt
- 40: Gesamtstrom
- 41: Stromwandler
- 42: Wicklungsrichtung
- 43: Wicklungsrichtung
- 44: Messdurchführung
- 45: Messeinrichtung
- 46: Lichtwellenleitung
- 47: Leitung
- 48: Leitung
- 49: Personal Computer
- 50: Ringleitungssystem
- 51: Temperatursensor
- 52: Temperatursensor.
- 53: Braggfaser
- 54: Messdurchführung
- 55: optoelektronische Messeinrichtung
- 56: Messstellen
- 57: Messstellen
- 58: Kühlmitteltemperatur
- 59: Temperatursensorstelle
- 60: Temperatursensorstelle
- 61: Gehäuse
- 62: Erregerstromzuführung

## Patentansprüche

1. Turbogenerator der eine Ständerwicklung mit einem ersten und einem zweiten Wicklungszweig aufweist,
**dadurch gekennzeichnet, dass**
eine Überwachungs- und Meldevorrichtung vorgesehen ist, die eine erste Messeinrichtung für die Messung einer physikalischen Größe im ersten Wicklungszweig und eine zweite Messeinrichtung im zweiten Wicklungszweig aufweist, wobei durch Vergleich einer Messung im ersten Wicklungszweig und einer Messung im zweiten Wicklungszweig ein Differenzwert gemessen wird und bei Überschreitung eines vorbestimmten Grenzwertes eine Störung erkannt wird.

2. Turbogenerator nach Anspruch 1,
**dadurch gekennzeichnet, dass**
die Messeinrichtung für die Messung einer physikalischen Größe einen Stromwandler aufweist.

3. Turbogenerator nach Anspruch 1,
**dadurch gekennzeichnet, dass**
die Messeinrichtung für die Messung einer physikalischen Größe einen Temperatursensor aufweist.

4. Turbogenerator nach Anspruch 1 oder 2,
**dadurch gekennzeichnet, dass**
der Stromwandler aus einem faseroptischen Stromwandler besteht.

5. Turbogenerator nach Anspruch 1 oder 3,
**dadurch gekennzeichnet, dass**
der Temperatursensor aus einem faseroptischen Temperatursensor besteht.

6. Turbogenerator nach Anspruch 1, 2 oder 4,
**dadurch gekennzeichnet, dass**
zur Überwachung des ersten und zweiten Wicklungszweigen zwei in Reihe geschaltete faseroptische Stromwandler vorgesehen sind, deren Wicklungsrichtungen zur jeweiligen Stromrichtung der Wicklungszweige gegenläufig sind.

7. Turbogenerator nach einem der Ansprüche 1 bis 6,
**dadurch gekennzeichnet, dass**
ein Speichermedium vorgesehen ist, in dem im störungsfreien Betrieb des Turbogenerators in Abhängigkeit vom Gesamtstrom eine Stromkennlinie gespeichert wird, wobei die Stromkennlinie aus einer Differenzmessung ermittelt wird und die Differenzmessung mit den Messeinrichtungen für die Messung einer physikalischen Größe die an jeweils einem Wicklungszweig installiert sind, durchgeführt wird.

8. Verfahren zur Überwachung einer Ständerwicklung eines Turbogenerators,
**dadurch gekennzeichnet, dass**
während des Betriebes sporadische oder zyklische Differenzmessungen durchgeführt werden und mit den während eines störungsfreien Betriebes gespeicherte Differenzmessungen verglichen werden, wobei eine Meldung generiert wird, wenn ein Unterschied zwischen den sporadisch oder zyklisch aufgenommenen Differenzmessungen und der während des störungsfreien Betriebes aufgenommenen und gespeicherten Differenzmessungen besteht.
